Europäisches Patentamt

European Patent Office

Office européen des brevets

(19)

(11) Publication number: **0 284 091 B1**

(12) **EUROPEAN PATENT SPECIFICATION**

(45) Date of publication of patent specification: **05.01.94** (51) Int. Cl.5: **G11C 7/00, G11C 17/08**

(21) Application number: **88104847.4**

(22) Date of filing: **25.03.88**

(54) Nonvolatile semiconductor memory device.

(30) Priority: **27.03.87 JP 71634/87**

(43) Date of publication of application:
**28.09.88 Bulletin 88/39**

(45) Publication of the grant of the patent:
**05.01.94 Bulletin 94/01**

(84) Designated Contracting States:
**DE FR GB**

(56) References cited:
**EP-A- 0 085 260**
**US-A- 4 223 394**

(73) Proprietor: **KABUSHIKI KAISHA TOSHIBA**
**72, Horikawa-cho**
**Saiwai-ku**
**Kawasaki-shi Kanagawa-ken 210(JP)**

(72) Inventor: **Shimamune, Yuji**
**Patent Division, K.K. Toshiba**
**1-1 Shibaura 1-chome**
**Minato-ku Tokyo 105(JP)**

(74) Representative: **Lehn, Werner, Dipl.-Ing. et al**
**Hoffmann, Eitle & Partner,**
**Patentanwälte,**
**Postfach 81 04 20**
**D-81904 München (DE)**

## Description

The present invention relates to a nonvolatile semiconductor memory device into which data can be electronically written, and more particularly, to a circuit for generating a reference potential of a sense amplifier for comparing the potential of a bit line to which memory cells are connected, with the reference potential of a dummy bit line to which a dummy cell is coupled.

A nonvolatile semiconductor memory device comprises a bit line, memory cells coupled to the bit line, a dummy bit line, a dummy cell coupled to the dummy bit line, a sense amplifier, a bit-line potential amplifying circuit, and a reference potential-generating circuit. The sense amplifier compares the potential of the bit line with the potential of the dummy bit line. Data is read, in the form of a voltage, from one of the memory cells which has been selected. This data voltage is amplified by the bit-line potential amplifying circuit. The reference potential-generating circuit generates reference potential of the dummy bit line. The reference potential-generating circuit includes a dummy bit-line potential amplifying circuit. The dummy bit-line potential amplifying circuit amplifies the potential of the dummy bit line, i.e., the data read from the dummy cell. Therefore, the sense amplifier compares the output voltages of the two potential amplifying circuits, and the difference between these voltages is the data read from the selected memory cell.

The reference potential and the bit-line potential, both applied to the sense amplifier, depend on the power-supply voltage of the semiconductor memory device. The depend on the power-supply voltage more greatly than the bit-line potential when the selected memory cell is one strong data "0". The power-supply voltage can increase from 0 V to a maximum value Vccmax until the reference potential Vref becomes substantially equal to the bit-line potential $V_{B0}$. The maximum value Vccmax of the power-supply voltage satisfies the following relationship:

$$V_{B0} = Vref > V_{B1}$$

where $V_{B1}$ is the potential which the bit line has when the selected memory cell is one strong data "1". When the power-supply voltage does not satisfy the above relationship, the sense amplifier makes errors.

The bit-line potential $V_{B0}$ and the reference potential Vref depend differently upon the power-supply voltage, since the bit-line potential amplifying circuit and the dummy bit-line potential amplifying circuit have different structures and, thus, different voltage-current characteristics. The main cause of the difference in voltage-current characteristic is the different in the number of resistive load transistors incorporated in these potential amplifying circuits.

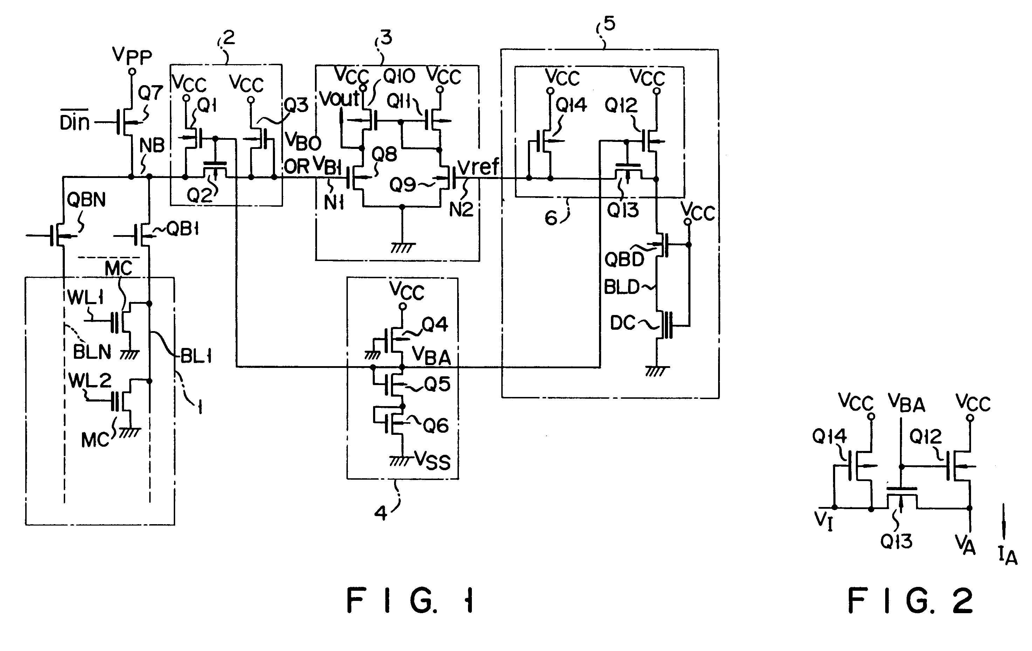

A conventional sense amplifier of the type described above is shown in S. Tanaka, et al., A Programmable 256K CMOS EPROM with On-Chip Test Circuits, ISSCC Digest of Technical Papers, Feb. 1984, pp. 148-149, Fig. 1. The circuit shown in Fig. 1 of this thesis compares a bit-line potential amplifying circuit and a dummy bit-line potential amplifying circuit. In the ordinary data-read mode, one transistor functions as a resistive load in the bit-line potential amplifying circuit, whereas two transistors function as resistive loads.

This sense amplifier does not have a sufficient margin of operation power-supply voltage. In other words, the difference between the standard power-supply voltage Vccstd and the maximum power-supply voltage Vccmax is not adequately large. Consequently, the sense amplifier is likely to malfunction not only by the changes of the power-supply voltage, but also by other causes such as the different parameters of the circuit elements and the incomplete data-writing into memory cells. More specifically, the sense amplifier may fail to operate correctly due to the different parameters of the circuit elements, even if is designed to generate a desired reference potential Vref when power-supply voltage Vcc of 5 V is applied to it, and even if this power-supply voltage of 5 V is actually applied to the sense amplifier.

As has been pointed out, the circuit for generating the reference potential of the sense amplifier used in the prior art nonvolatile semiconductor memory device has an operation margin too narrow to compensate for the difference in parameter among the circuit elements or for the changes of the power-supply voltage.

US-A-4 223 394 describes an MOS sensing amplifier for sensing the binary state of floating gate memory devices in a read-only memory. The potentials on the column lines in the memory are held to a narrow voltage swing. A pair of "zero" threshold voltages are used to maintain the potentials on these lines. A potential developed from the column lines is compared with a reference potential developed with a "dummy" biasing network and a "dummy" floating gate memory device. A biasing circuit is used to provide a non-volatile semiconductor memory with a broad operation margin. By adding the biasing circuit it is possible to make the dummy cell conduct less than a conducting memory cell.

Accordingly, it is the aim of the present invention to provide a simpler non-volatile semiconductor memory device which has a broad operation margin and can operate correctly even if the power-supply voltage changes or even if the elements incorporated in the device have their characteristics changed from their design values during the manufacturing process of the memory device.

According to the invention which is defined by the claims, there is provided a nonvolatile semiconductor memory device which comprises a plurality of row lines; a plurality of memory cells connected to the row lines and selectively driven to store data electronically; a plurality of column lines for receiving data read from the memory cells; a column line-selecting circuit for selecting one of the column lines; a first amplifier circuit for amplifying the data potential read from the column line selected by the column line-selecting circuit; a dummy cell capable of storing data electronically; a dummy column line connected to the dummy cell; a dummy column line selecting circuit having the same load characteristic as the column line selecting circuit has when selecting one of the column lines, and adapted for selecting the dummy column line; a second amplifier circuit for amplifying data potential read from the dummy cell selected by the dummy column line selecting circuit; a bias voltage-generating circuit for applying a bias voltage to the first and second amplifier circuits; and a comparator circuit for comparing the voltages output from the first and second amplifier circuits. The first amplifier circuit includes a first MOS transistor of N-channel type having a source electrode connected to the column line selecting circuit, a drain electrode connected to a power supply, and a gate electrode connected to the bias voltage-generating circuit to receive the bias voltage; a second MOS transistor of P-channel type having a drain electrode and gate electrode, both connected to a first input terminal of the comparator circuit, a source electrode connected to the power supply; and a third MOS transistor of the N-channel type having a source electrode connected to the column line selecting circuit, a drain electrode connected to the first input terminal of the comparator circuit, and a gate electrode connected to the bias voltage-generating circuit to receive the bias voltage. The second amplifier circuit includes a fourth MOS transistor of the N-channel type having a drain electrode connected to the power supply, a source electrode connected to the dummy column line selecting circuit, and a gate electrode connected to the bias voltage-generating circuit to receive the bias voltage; a fifth MOS transistor of the P-channel type having a source electrode connected to the power supply, and a drain electrode and a gate electrode, both connected to a second input terminal of the comparator circuit; and a sixth MOS transistor of the N-channel type having a drain electrode connected to the second input terminal of the comparator circuit, a source electrode connected to the dummy column line selecting circuit, a gate electrode connected to the bias voltage-generating circuit to receive the bias voltage. The second and fifth MOS transistors have the same element size, and the third and sixth MOS transistors have the same element size. The fourth MOS transistor is able to drive more current than the first MOS transistor.

The second MOS transistor incorporated in the first amplifier circuit and the fifth MOS transistor incorporated in the second amplifier circuit have identical voltage-current characteristic. Similarly, the third MOS transistor used in the first amplifier circuit and the sixth MOS transistor used in the second amplifier circuit have identical voltage-current characteristic. Since the first and fourth MOS transistor are driven by a current to different degree, a difference always exists between the potentials of the two input terminals of the comparator circuit. Further, the comparator circuit has a small power-supply voltage dependency since its two input nodes have the same voltage-current characteristic. In addition, the first and second amplifier circuits have identical operation characteristics since the first to sixth MOS transistors, which constitute these amplifier circuits, have been manufactured in the same process, and their characteristics have changed, if any, from the design values to the same extent. Therefore, the nonvolatile semiconductor memory device according to the present invention has a broad operation margin and can operate correctly even if the power-supply voltage changes, or even if its constituent elements have their characteristics changed during the manufacture of the memory device.

This invention can be more fully understood from the following detailed description when taken in conjunction with the accompanying drawings, in which:

Fig. 1 is a circuit diagram schematically showing a nonvolatile semiconductor memory device according to an embodiment of the present invention;

Fig. 2 is a circuit diagram showing the dummy bit-line potential amplifying circuit incorporated in the device shown in Fig. 1; and

Fig. 3 is a graph representing the voltage-current characteristic of the sense amplifier incorporated in the device shown in Fig. 1.

Fig. 1 schematically shows a part of the memory cell array, the sense amplifier, and the like of a nonvolatile semiconductor memory device according to one embodiment of the present invention. This memory device is an EPROM storing data which can be erased by applying ultraviolet rays to the memory cell array.

As is shown in Fig. 1, the memory cell array 1 includes memory cells MC having a floating gate and arranged in rows and columns. The control gates of memory cells MC are connected to word lines (i.e., row lines) WL1, WL2, ..., respectively. The source-drain path of each memory cell MC is connected between one of bit lines (i.e., column lines) BL1 to BLN and the ground. Bit lines BL1 to BLN are coupled, at one end, to N-channel MOS transistors QB1 to QBN. Transistors QB1 to QBN are switching elements for selecting bit lines BL1 to BLN. These transistors QB1 to QBN are connected, at one end, to bit lines BL1 to BLN and, at the other end, to one another. Transistors QB1 to QBN are switched on or off in accordance with the output of a column decoder (not shown).

Bit-line potential amplifying circuit 2 is connected to node NB of bit lines BL1 to BLN. Circuit 2 has an output node which is coupled to the first input node N1 of comparator circuit 3 which is a differential amplifier (e.g., a comparator circuit of a P-channel, current mirror type).

Bit-line potential amplifier circuit 2 comprises an N-channel MOS transistor Q1, an N-channel MOS transistor Q2, and a P-channel MOS transistor Q3. MOS transistor Q1 is used to clamp the potential of bit lines BL1 to BLN. MOS transistor Q2 functions to amplify the potential of the bit lines. MOS transistor Q3 functions as a load of MOS transistor Q2. The source-drain path of MOS transistor Q1 is connected between a Vcc power-supply node and node NB of the bit lines. The source-drain path of MOS transistor Q2 is connected in series with the bit lines, so as to detect the data potential applied to node NB of the bit lines. The drain-source path of MOS transistor Q3 is coupled between the Vcc power-supply node and the drain of MOS transistor Q2. The gate and drain electrodes of MOS transistor Q3 are connected to each other.

Bias voltage-generating circuit 4 applies a predetermined bias voltage $V_{BA}$ to the gate electrodes of MOS transistors Q1 and Q2 of bit-line potential amplifying circuit 2. The bias voltage-generating circuit comprises P-channel MOS transistor Q4 and N-channel MOS transistors Q5 and Q6, whose current paths are connected in series and which form a series circuit coupled between the Vcc power-supply node and a Vss power-supply node (i.e., the ground). The gate electrode of MOS transistor Q4 is grounded. The drain electrode of MOS transistor Q5 is connected to the gate electrode of this MOS transistor Q5, and the drain electrode of MOS transistor Q6 is connected to the gate electrode of this transistor Q6.

The threshold voltage $V_{TH}$ of each memory cell MC is either at a high level (data "0" being stored in the memory cell), or at a low level (data "1" being stored in the memory cell). When the memory cell MC is selected, its threshold voltage $V_{TH}$, which is at the high or low level, is applied to the first input node N1 of comparator circuit 3. More precisely, bit-line potential $V_B$, which has been amplified by bit-line potential amplifying circuit 2, is applied to first input node N1. (The potential $V_B$ has value $V_{B0}$ when the selected memory cell is one storing data "0", and value $V_{B1}$ when the selected memory cell is one storing data "1".

MOS transistor Q7 is used to control the writing of data into memory cells MC. The source-drain path of this MOS transistor is connected between node NB of the bit lines and a high-voltage Vpp node to which a data-write voltage is applied. MOS transistor Q7 is switched on or off in accordance with signal $\overline{Din}$ obtained by inverting a write-in signal Din. Thus, to write data into a selected memory cell MC, the high voltage Vpp is applied to the control gate electrode and drain electrode of this MOS transistor Q7 simultaneously.

Comparator circuit 3 comprises two N-channel MOS transistors Q8 and Q9 forming a differential pair, and two P-channel MOS transistors Q10 and Q11 constituting a current mirror load. The gate electrode of MOS transistor Q8 is coupled to first input node N1. Source electrode of transistor Q8 is connected to the ground. The gate electrode of MOS transistor Q9 is connected the second input node N2 of comparator circuit 3. Source electrode of transistor Q9 is connected to the ground. The drain-source path of MOS transistor Q10 is connected between a drain electrode of MOS transistor Q8 and the Vcc power-supply node. The drain-source path of MOS transistor Q11 is connected between a drain electrode of MOS transistor Q9 and the Vcc power-supply node. The gates electrodes of MOS transistors Q10 and Q11 are coupled with each other. The node of the gate electrodes of these MOS transistors is coupled to the drain electrode of MOS transistor Q9. An output signal Vout is supplied from the node of MOS transistors Q8 and Q10.

The memory device comprises reference potential-generating circuit 5 designed for applying a reference potential Vref to the second input node N2 of comparator circuit 3. As can be understood from Fig. 1, circuit 5 is similar to the combination of memory cell array 1 and bit line selecting MOS transistors QB1 to QBN. Circuit 5 comprises dummy cell DC, dummy bit line BLD, N-channel MOS transistor QBD, and dummy bit-line potential amplifying circuit 6. Dummy cell DC is coupled to dummy bit line BLD. MOS transistor QBD is connected in series to dummy bit line BLD, for selecting dummy bit line BLD, and thus corresponds to N-channel MOS transistors QB1 to QBN which are used to select bit lines BL1 to BLN. MOS transistor QBD has the same characteristic as MOS transistors QB1 to QBN.

Dummy bit-line potential amplifying circuit 6 is connected to one end of MOS transistor QBD. Circuit 6 comprises N-channel MOS transistor Q12 for clamping the dummy bit-line potential, N-channel MOS transistor Q13 for amplifying the dummy bit-line potential, and P-channel MOS transistor Q14 functioning as a load of transistor Q13. The source-drain path of MOS transistor Q12 is connected between one end of MOS transistor QBD and the Vcc power-supply node. The source-drain path of MOS transistor Q13 is connected in series to dummy bit line BLD, so as to detect reference data read out of dummy cell DC. The drain-source path of MOS transistor Q14 is connected between the drain electrode of MOS transistor Q13 and the Vcc power-supply node. The gate and drain electrodes of transistor Q14 are coupled to each other. Bias voltage $V_{BA}$ is applied from bias voltage-generating circuit 4 to the gate electrodes of MOS transistors Q12 and Q13. Data "1" is stored in dummy cell DC, and dummy cell DC is in the erased condition. A control voltage (i.e., the Vcc potential) is applied to the control gate electrode of dummy cell DC. The Vcc potential is applied to the gate electrode of MOS transistor QBD for selecting dummy bit line BLD.

The reference potential Vref generated by reference potential-generating circuit 5 is lower than the bit line potential $V_{B0}$ and higher than $V_{B1}$. That is, $V_{B0} > Vref > V_{B1}$, whereby comparator circuit 3 outputs a correct output signal Vout. This is because MOS transistor Q13 has the same element size as MOS transistor Q2, MOS transistor Q14 has the same element size as MOS transistor Q3, and MOS transistor Q12 has a greater channel width than that of MOS transistor Q1 and is, thus, more readily driven by a current than MOS transistor Q1. Hence, the potential-amplifying path comprised of MOS transistors Q13 and Q14, and the potential-amplifying path comprised of MOS transistors Q2 and Q3 have an identical voltage-current characteristic. Since MOS transistors Q1 and Q12 are driven by a current to different extents, the potentials of input nodes N1 and N2 of comparator circuit 3 are different, and comparator circuit 3 therefore produces a correct output signal Vout.

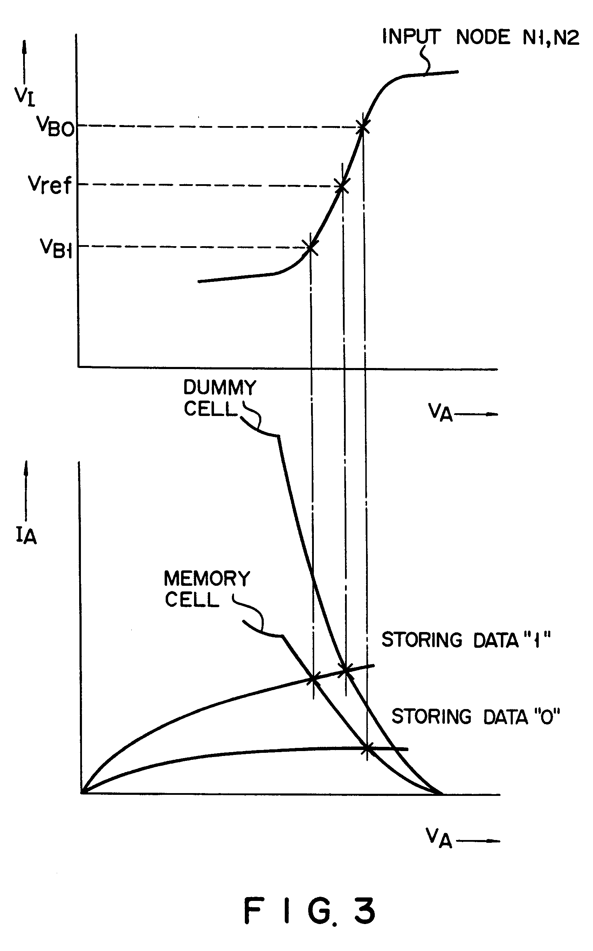

Fig. 2 is a circuit diagram showing dummy bit-line potential amplifying circuit 6. Fig. 3 is a graph illustrating the input voltage-output voltage characteristic of amplifying circuits 2 and 6, and the voltage-current characteristics of a memory cell storing data "1", a memory cell storing data "0", and dummy cell DC. As is evident from Fig. 3, input nodes N1 and N2 of comparator circuit 3 have the same voltage-current characteristic. Obviously, comparator circuit 3 has a small power-supply voltage dependency. Since bit-line potential amplifying circuit 2 and dummy bit-line potential amplifying circuit 6 are similar in structure, the parameters of their constituent elements have changed, if they have from the design values to the same extent during the manufacturing process. Therefore, the relationship of $V_{B0} > Vref > V_{B1}$ is maintained. As a result, the operation margin of the memory device increases; in particular, maximum operation power-supply voltage Vccmax increases.

As has been described above, the present invention can provide a nonvolatile semiconductor memory device which has a broad operation margin and can operate correctly even if the power-supply voltage changes, or even if its constituent elements have their characteristics changed during the manufacture of the memory device.

**Claims**

1. A nonvolatile semiconductor memory device comprising a plurality of row lines (WL1, WL2, ...); a plurality of nonvolatile memory cell (MC) selectively driven by said row lines (WL1, WL2, ...) for storing data electronically; a plurality of column lines (BL1 to BLN) for receiving data read from the memory cells (MC); a column line-selecting means (QB1 to QBN) connected to one end of each of the column lines (BL1 to BLN), for selecting one of the column lines (BL1 to BLN); first amplifier means (2) for amplifying the data potential read from the column line selected by the column line-selecting means (QB1 to QBN); a dummy cell (DC) capable of storing data electronically; a dummy column line (BLD) connected to the dummy cell (DC); dummy-column line selecting means (QBD) having the same load characteristic as the column line-selecting means (QB1 to QBN) has when selecting one of the column lines (BL1 to BLN), and adapted for selecting the dummy column line (BLD); second amplifier means (6) for amplifying the data potential read from the dummy cell (DC); bias voltage-generating means (4) for applying a bias voltage ($V_{BA}$) to the first and second amplifier means (2, 6); and comparator means (3) for comparing the voltages ($V_{B0}$ or $V_{B1}$, Vref) output from said first and second amplifier means (2, 6), thereby to output the data potential read from the selected memory cell (MC), wherein

   said first amplifier means (2) includes a first MOS transistor (Q1) of N-channel type having a drain electrode connected to a power supply (Vcc), a source electrode connected to said column line-selecting means (QB1 to QBN), and a gate electrode connected to said bias voltage-generating means (4) to receive the bias voltage ($V_{BA}$), a second MOS transistor (Q3), and a third MOS transistor (Q2) of the N-channel type having a drain electrode connected to the first input terminal of said comparator means (3), a source electrode connected to said column line-selecting means (QB1 to QBN), and a gate electrode connected to said bias voltage-generating means (4) to receive the bias voltage ($V_{BA}$); and

said second amplifier means (5) includes a fourth MOS transistor (Q12) of the N-channel type having a drain electrode connected to the power supply (Vcc), a source electrode connected to said dummy-column line selecting means (QBD), and a gate electrode connected to said bias voltage-generating means (4) to receive the bias voltage ($V_{BA}$), a fifth MOS transistor (Q14) and a sixth MOS transistor (Q13) of the N-channel type having a drain electrode connected to the second input terminal of said comparator means (3), a source electrode connected to said dummy-column line selecting means (QBD), and a gate electrode connected to said bias voltage-generating means (4) to receive the bias voltage ($V_{BA}$), said fifth MOS transistor (Q14) having the same element size as said second MOS transistor (Q3), said sixth MOS transistor (Q13) having the same element size as said third MOS transistor (Q2), **characterized in that** said second and fifth MOS transistors (Q3,Q14) are of the P-channel type having source electrodes connected to the power supply ($V_{cc}$), drain and gate electrodes of said second MOS transistor (Q3) both being connected to a first input terminal of said comparator means (3) and drain and gate electrodes of said fifth MOS transistor (Q14) both being connected to a second input terminal of said comparator means (3), and said fourth MOS transistor (Q12) has a greater channel width than said first MOS transistor (Q1).

2. The semiconductor memory device according to claim 1, characterized in that said comparator means (3) includes a seventh MOS transistor (Q8) having a gate electrode connected to the output terminal of said first amplifier means (2), an eighth MOS transistor (Q9) having a gate electrode connected to the output terminal of said second amplifier means (6) and a source electrode connected to a source electrode of said seventh MOS transistor (Q8), and a current mirror circuit for supplying the same current to said seventh and eighth MOS transistors (Q8, Q9).

3. The semiconductor memory device according to claim 1, characterized in that said bias voltage-generating means (4) includes a ninth MOS transistor (Q4) of the P-channel type having one end connected to the power-supply (Vcc) and a gate electrode connected to the ground, a tenth MOS transistor (Q5) of the N-channel type having a drain electrode and a gate electrode, both connected to the other end of said ninth MOS transistor (Q4), and an eleventh MOS transistor (Q6) of the N-channel type having a drain electrode and a gate electrode, both connected to the source electrode of said tenth MOS transistor (Q5) and the source electrode connected to the ground (Vss), and said bias voltage is output from the node of said ninth MOS transistor (Q4) and said tenth MOS transistor (Q5).

4. The semiconductor memory device according to claim 1, characterized in that said column line-selecting means includes a plurality of MOS transistors (QB1 to QBN) connected, at one end, to said column line (BL1 to BLN), and at the other end, to one another.

5. The semiconductor memory device according to claim 4, characterized in that said dummy-column line selecting means includes a MOS transistor (QBD) connected, at one end, to said dummy column line (BLD), and at the other end, to the input terminal of said second amplifier means, and having the same characteristic as the MOS transistors (QB1 to QBN) included in said column line-selecting means.

**Patentansprüche**

1. Nicht-flüchtige Halbleiterspeichervorrichtung, mit einer Vielzahl von Zeilenleitungen (WL1, WL2, ...); einer Vielzahl von nicht-flüchtigen Speicherzellen (MC), die selektiv von den Zeilenleitungen (WL1, WL2, ...) getrieben werden, um Daten elektronisch zu speichern; einer Vielzahl von Spaltenleitungen (BL1 bis BLN), um von den Speicherzellen (MC) gelesene Daten zu empfangen; einer Spaltenleitungs-Auswahleinrichtung (QB1 bis QBN), die mit einem Ende jeder der Spaltenleitungen (BL1 bis BLN) verbunden ist, um eine der Spaltenleitungen (BL1 bis BLN) auszuwählen; ersten Verstärkereinrichtungen (2) zum Verstärken des von der von den Spaltenleitungs-Auswahleinrichtungen (QB1 bis QBN) gewählten Spaltenleitung gelesenen Datenpotentials; einer Dummyzelle (DC), die in der Lage ist, Daten elektronisch zu speichern; einer mit der Dummyzelle (DC) verbundenen Spaltenleitung (BLD); Dummyspaltenleitungs-Auswahleinrichtungen (QBD), die dieselbe Lastcharakteristik haben wie die Spaltenleitungs-Auswahleinrichtungen (QB1 bis QBN), wenn eine der Spaltenleitungen (BL1 bis BLN) gewählt wird, und angepaßt ist zum Wählen der Dummyspaltenleitung (BLD); zweiten Verstärkereinrichtungen (6) zum Verstärken des von der Dummyzelle (DC) gelesenen Datenpotentials; Vorspannungs-Erzeugungseinrichtungen (4) zum Anlegen einer Vorspannung ($V_{BA}$) an die ersten und zweiten Verstärkereinrichtungen (2, 6); und Komparatoreinrichtungen (3) zum Vergleichen der von den ersten und zweiten Verstärkereinrichtungen (2, 6) ausgegebenen Spannungen ($V_{B0}$ oder $V_{B1}$, Vref), um dadurch das von der ausgewählten Speicherzelle (MC) gelesene Datenpotential auszugeben,

worin die erste Verstärkereinrichtung (2) einen ersten MOS-Transistor (Q1) vom N-Kanal-Typ einschließt, mit einer mit einer Stromversorgung (Vcc) verbundenen Drainelektrode, einer mit den Spaltenleitungs-Auswahleinrichtungen (QB1 bis QBN) verbundenen Sourceelektrode, und einer mit den Vorspannungserzeugungseinrichtungen (4) verbundenen Gateelektrode, um die Vorspannung ($V_{BA}$) zu empfangen, einen zweiten MOS-Transistor (Q3), und einen MOS-Transistor (Q2) vom N-Kanal-Typ, mit einer mit dem ersten Eingangsanschluß der Komparatoreinrichtung (3) verbundenen Drainelektrode, einer mit den Spaltenleitungs-Auswahleinrichtungen (QB1 bis QBN) verbundenen Sourceelektrode, und einer mit den Vorspannungerzeugungseinrichtungen (4) verbundenen Gateelektrode, um die Vorspannung ($V_{BA}$) zu empfangen, und

die zweite Verstärkereinrichtung einen vierten MOS-Transistor (Q12) des N-Kanal-Typs einschließt, mit einer mit der Stromversorgung (Vcc) verbundenen Drainelektrode, einer mit den Dummy-Spaltenleitungs-Auswahleinrichtungen (QBD) verbundenen Sourceelektrode, und einer mit den Vorspannungs-Erzeugungseinrichtungen (4) verbundenen Gateelektrode, um die Vorspannung ($V_{BA}$) aufzunehmen, einen fünften MOS-Transistor (Q14) und einen sechsten MOS-Transistor (Q13) vom N-Kanal-Typ, mit einer mit dem zweiten Eingangsanschluß der Komparatoreinrichtungen (3) verbundenen Drainelektrode, einer mit den Dummy-Spaltenleitungs-Auswahleinrichtungen (QBD) verbundenen Sourceelektrode, und einer mit den Vorspannungs-Erzeugungseinrichtungen (4) verbundenen Gateelektrode, um die Vorspannung ($V_{BA}$) zu empfangen, wobei der fünfte MOS-Transistor (Q14) dieselbe Elementgröße wie der zweite MOS-Transistor (Q3) hat, und der sechste MOS Transistor (Q13) dieselbe Elementgröße wie der dritte MOS-Transistor (Q2),

**dadurch gekennzeichnet**, daß die zweiten und fünften MOS-Transistoren (Q3, Q14) vom P-Kanal-Typ sind, deren Sourceelektroden mit der Stromversorgung ($V_{cc}$) verbunden sind, Drain- und Gateelektroden des zweiten MOS-Transistors (Q3) beide mit einem ersten Eingangsanschluß der Komparatoreinrichtung (3) verbunden sind, und Drain- und Gateelektroden des fünften MOS-Transistors (Q14) beide mit einem zweiten Eingangsanschluß der Komparatoreinrichtung (3) verbunden sind, und der vierte MOS-Transistor (Q12) eine größere Kanalbreite aufweist als der erste MOS-Transistor (Q1).

2. Halbleiterspeichervorrichtung nach Anspruch 1, **dadurch gekennzeichnet**, daß die Komparatoreinrichtung (3) einen siebten MOS-Transistor (Q8) mit einer mit dem Ausgangsanschluß der ersten Verstärkereinrichtung (2) verbundenen Gateelektrode einschließt, einen achten MOS-Transistor (Q9) mit einer mit dem Ausgangsanschluß der zweiten Verstärkereinrichtung (6) verbundenen Gateelektrode und einer mit einer Sourceelektrode des siebten MOS-Transistors (Q8) verbundenen Sourceelektrode, und einen Stromspiegelschaltkreis zum Liefern desselben Stroms an die siebten und achten MOS-Transistoren (Q8, Q9).

3. Halbleiterspeichervorrichtung nach Anspruch 1, **dadurch gekennzeichnet**, daß die Vorspannungs-Erzeugungseinrichtung (4) einen neunten MOS-Transistor (Q4) vom P-Kanal-Typ einschließt, dessen eines Ende mit der Stromversorgung (Vcc) verbunden ist, und mit einer mit Masse verbundenen Gateelektrode, einen zehnten MOS-Transistor (Q5) vom N-Kanal-Typ mit einer Drainelektrode und einer Gateelektrode, die beide mit dem anderen Ende des neunten MOS-Transistors (Q4) verbunden sind, und einen elften MOS-Transistor (Q6) vom N-Kanal-Typ, mit einer Drainelektrode und einer Gateelektrode, die beide mit der Sourceelektrode des zehnten MOS-Transistors (Q5) verbunden sind, und dessen Sourceelektrode mit Masse (Vss) verbunden ist, und die Vorspannung von dem Knoten des neunten MOS-Transistors (Q4) und des zehnten MOS-Transistors (Q5) ausgegeben wird.

4. Halbleiterspeichervorrichtung nach Anspruch 1, **dadurch gekennzeichnet**, daß die Spaltenleitungs-Auswahleinrichtung eine Vielzahl von MOS-Transistoren (QB1 bis QBN) einschließt, die mit einem Ende mit der Spaltenleitung (BL1 bis BLN) verbunden sind, und mit dem anderen Ende miteinander.

5. Halbleiterspeichervorrichtung nach Anspruch 4, **dadurch gekennzeichnet**, daß die Dummy-Spaltenleitungs-Auswahleinrichtung einen MOS-Transistor (QBD) einschließt, der mit einem Ende mit der Dummy-Spaltenleitung (BLD) verbunden ist, und mit dem anderen Ende mit dem Eingangsanschluß der zweiten Verstärkereinrichtung, und dieselbe Charakteristik wie die MOS-Transistoren (QB1 bis QBN), die in der Spaltenleitungs-Auswahleinrichtung eingeschlossen sind, aufweist.

## Revendications

1. Dispositif de mémoire à semiconducteur non volatile comprenant une pluralité de lignes de rangée (WL1, WL2, ...) ; une pluralité de cellules de mémoire non volatile (MC) commandées sélectivement par lesdites lignes de rangée (WL1, WL2, ...) pour stocker électroniquement des données ; une pluralité de lignes de colonne (BL1 à BLN) pour recevoir des données lues dans les cellules de mémoire (MC) ; un moyen de sélection de ligne de colonne (QB1 à QBN) connecté à une extrémité de chacune des lignes de colonne (BL1 à BLN) pour sélectionner l'une des lignes de colonne (BL1 à BLN) ; un premier moyen d'amplificateur (2) pour amplifier le potentiel des données lues dans la ligne de colonne sélectionnée par le moyen de sélection de ligne de colonne (QB1 à QBN) ; une cellule fictive (DC) pouvant stocker électroniquement des données ; une ligne de colonne fictive (BLD) connectée à la cellule fictive (DC) ; un moyen de sélection de ligne de colonne fictive (QBD) présentant la même caractéristique de charge que celle que le moyen de sélection de ligne de colonne (QB1 à QBN) possède lors de la sélection de l'une des lignes de colonne (BL1 à BLN) et conçu pour sélectionner la ligne de colonne fictive (BLD) ; un second moyen d'amplificateur (6) pour amplifier le potentiel des données lues dans la cellule fictive (DC) ; un moyen de génération de tension de polarisation (4) pour appliquer une tension de polarisation ($V_{BA}$) aux premier et second moyens d'amplificateur (2, 6) ; et un moyen de comparateur (3) pour comparer les tensions ($V_{B0}$ ou $V_{B1}$, Vref) émises en sortie depuis lesdits premier et second moyens d'amplificateur (2, 6) afin d'ainsi émettre en sortie le potentiel des données lu dans la cellule de mémoire sélectionnée (MC),

dans lequel ledit premier moyen d'amplificateur (2) inclut un premier transistor MOS (Q1) du type à canal N comportant une électrode de drain connectée à une alimentation (Vcc), une électrode de source connectée audit moyen de sélection de ligne de colonne (QB1 à QBN) et une électrode de grille connectée audit moyen de génération de tension de polarisation (4) pour recevoir la tension de polarisation ($V_{BA}$), un second transistor MOS (Q3) et un troisième transistor MOS (Q2) du type à canal N comportant une électrode de drain connectée à la première borne d'entrée dudit moyen de comparateur (3), une électrode de source connectée audit moyen de sélection de ligne de colonne (QB1 à QBN) et une électrode de grille connectée audit moyen de génération de tension de polarisation (4) pour recevoir la tension de polarisation ($V_{BA}$) ; et

ledit second moyen d'amplificateur (5) inclut un quatrième transistor MOS (Q12) du type à canal N comportant une électrode de drain connectée à l'alimentation (Vcc), une électrode de source connectée audit moyen de sélection de ligne de colonne fictive (QBD) et une électrode de grille connectée audit moyen de génération de tension de polarisation (4) pour recevoir la tension de polarisation ($V_{BA}$), un cinquième transistor MOS (Q14) et un sixième transistor MOS (Q13) du type à canal N comportant une électrode de drain connectée à la seconde borne d'entrée dudit moyen de comparateur (3), une électrode de source connectée audit moyen de sélection de ligne de colonne fictive (QBD) et une électrode de grille connectée audit moyen de génération de tension de polarisation (4) pour recevoir la tension de polarisation ($V_{BA}$), ledit cinquième transistor MOS (Q14) présentant la même dimension élémentaire que ledit second transistor MOS (Q3), ledit sixième transistor MOS (Q13) présentant la même dimension élémentaire que ledit troisième transistor MOS (Q2), caractérisé en ce que lesdits second et cinquième transistors MOS (Q3, Q14) sont du type à canal P comportant des électrodes de source connectées à l'alimentation ($V_{cc}$) et des électrodes de drain et de grille dudit second transistor MOS (Q3) étant toutes deux connectées à une première borne d'entrée dudit moyen de comparateur (3) et des électrodes de drain et de grille dudit cinquième transistor MOS (Q14) étant toutes deux connectées à une seconde borne d'entrée dudit moyen de comparateur (3) et ledit quatrième transistor MOS (Q12) présentant une largeur de canal supérieure à celle dudit premier transistor MOS (Q1).

2. Dispositif de mémoire à semiconducteur selon la revendication 1, caractérisé en ce que ledit moyen de comparateur (3) inclut un septième transistor MOS (Q8) comportant une électrode de grille connectée à la borne de sortie dudit premier moyen d'amplificateur (2), un huitième transistor MOS (Q9) comportant une électrode de grille connectée à la borne de sortie dudit second moyen d'amplificateur (6) et une électrode de source connectée à une électrode de source dudit septième transistor MOS (Q8) et un circuit miroir de courant pour appliquer le même courant auxdits septième et huitième transistors MOS (Q8, Q9).

3. Dispositif de mémoire à semiconducteur selon la revendication 1, caractérisé en ce que ledit moyen de génération de tension de polarisation (4) inclut un neuvième transistor MOS (Q4) du type à canal P comportant une extrémité connectée à l'alimentation (Vcc) et une électrode de grille connectée à la masse, un dixième transistor MOS (Q5) du type à canal N comportant une électrode de drain et une électrode de grille toutes deux connectées à l'autre extrémité dudit neuvième transistor MOS (Q4) et un onzième transistor MOS (Q6) du type à canal N comportant une électrode de drain et une électrode de grille toutes deux connectées à l'électrode de source dudit dixième transistor MOS (Q5) et l'électrode de source connectée à la masse (Vss) et ladite tension de polarisation est émise en sortie depuis le noeud dudit neuvième transistor MOS (Q4) et dudit dixième transistor MOS (Q5).

4. Dispositif de mémoire à semiconducteur selon la revendication 1, caractérisé en ce que ledit moyen de sélection de ligne de colonne inclut une pluralité de transistors MOS (QB1 à QBN) connectés au niveau d'une extrémité à ladite ligne de colonne (BL1 à BLN) et au niveau de l'autre extrémité les uns aux autres.

5. Dispositif de mémoire à semiconducteur selon la revendication 4, caractérisé en ce que ledit moyen de sélection de ligne de colonne fictive inclut un transistor MOS (QBD) connecté au niveau d'une extrémité à ladite ligne de colonne fictive (BLD) et au niveau de l'autre extrémité à la borne d'entrée dudit second moyen d'amplificateur et présentant la même caractéristique que celle des transistors MOS (QB1 à QBN) inclus dans ledit moyen de sélection de ligne de colonne.

F I G. 1

F I G. 2

F I G. 3